# EUROPEAN PATENT APPLICATION

(11) **EP 2 495 779 A2**
(43) Date of publication of application: **05.09.2012**
(21) Application number: 12157910.6
(22) Date of filing: 02.03.2012
(51) Int. Cl.: H01L 51/00, G02F 1/00, H05K 1/00

(54) **Method for manufacturing thin-film substrate**

(30) Priority: 04.03.2011 JP 2011048375
(71) Applicant: Nitto Denko Corporation, Osaka 567-8680 (JP)
(72) Inventor: Shintani, Toshio, Osaka, 567-8680 (JP); Arimitsu, Yukio, Osaka, 567-8680 (JP)
(74) Representative: Grünecker, Kinkeldey, Stockmair & Schwanhäusser

(57) **Abstract**

The present invention provides a manufacturing method for efficiently and stably forming a pattern on a thin-film substrate. The method for manufacturing the thin-film substrate includes: stacking the thin-film substrate, a tackiness/adhesive agent for temporary fixing and a hard substrate in this order; fixing the thin-film substrate on the hard substrate through the tackiness/adhesive agent; then forming the pattern; and subsequently peeling the thin-film substrate at an interface between the thin-film substrate and the tackiness/adhesive agent.

## Description

### BACKGROUND OF THE INVENTION

### Field of the Invention

The present invention relates to a method for forming a pattern on a thin-film substrate, and more specifically relates to: a method for forming a pattern onto a thin-film substrate in the manufacture of a flexible printed circuit board (FPC), a base substrate of an organic EL panel, a driving circuit of an electronic paper or a flexible display, and a circuit board of a passive matrix or a color filter and a touch panel, or in a film-forming process of a solar cell; and a tackiness/adhesive agent to be used for the method.

### Description of the Related Art

Conventionally, a circuit board, a base substrate of an organic EL panel and a substrate of a color filter and the like had have rigidity because of having thickness, and accordingly it has been possible to fix these substrates at an accurate position and form a pattern on the substrates, without worrying about handling of fixation, movement or the like of the substrate, when the pattern is formed on these substrates. Actually, the driving circuit or the circuit board of the color filter or the touch panel is usually formed on a glass substrate, and any problem has not occurred when the pattern is formed on the glass substrate having such a sufficient rigidity.

However, recently, the development of a type having a feature of being light, being hard to be destroyed even when having received a shock, and besides, being thin, has started in parts in an electronic device and displays, which are more specially a flexible printed circuit board (FPC), a base substrate of an organic EL panel, a TFT (driving circuit) of an electronic paper and a flexible display, and a circuit board of a passive matrix or a color filter and a touch panel, themselves.

In this case, the pattern of the driving circuit, the circuit board of the passive matrix, the color filter and the touch panel, and the like needs to be formed not on a conventional glass substrate but on a so-called metal foil having heat resistance and a plastic substrate. However, these metal foil and plastic substrate are a thin film and accordingly have such many problems as to be hard to be accurately fixed and be transported.
Particularly, when the pattern is formed on the substrate, the position deviates due to a slight distortion of the substrate, which consequently results in greatly decreasing an yield. In addition, such a problem occur that even when the substrate is fixed by using an adsorption plate using a porous plate, and the position deviates due to a slight recess of the adsorption portion, which consequently results in greatly decreasing the yield.

For this reason, Philips Corporation has proposed a method of applying polyimide onto a glass and separating the polyimide substrate from the glass using a transfer technology, in order to develop an α-Si TFT-EPD display. However, in this case, the method requires to use a laser annealing process in order to remove the glass substrate, and as a result, the method has such problems that a new facility is required or an inexpensive thin-film substrate cannot be used from the viewpoint of heat resistance.
Furthermore, recently, a Roll to Roll forming process is also tried. However, in this case, the process is not a conventional batch process, accordingly an existing TFT facility cannot be used, and a new facility is needed. The process also must overcome several problems originating in the rotation and contact of the rolled substrate.
On the other hand, as is described in Japanese Patent Laid-Open No. 2007-12815, there is known a method as a method for manufacturing a flexible display, which includes the steps of: forming a release layer on a temporal substrate; forming a TFT with a structure on the release layer, in which a gate electrode, a gate insulation layer and an organic active layer are formed sequentially from the bottom, and a source electrode and a drain electrode are electrically connected to the organic active layer, and forming a pixel electrode that is electrically connected to the drain electrode of the TFT; forming a barrier insulation layer on or in the upper part of the TFT; bonding a plastic film onto the barrier insulation layer through an adhesive layer; peeling the temporal substrate from an interface between the temporal substrate and the release layer, and thereby transferring/forming the barrier insulation layer, the TFT, the pixel electrode and the release layer onto/on the plastic film through the adhesive layer, in a state of having reversed those; removing the release layer, and exposing one part of the TFT and the pixel electrode; forming each of an organic EL layer containing a light-emitting layer on the pixel electrodes in each of the pixels; forming a metal electrode on the organic EL layer; and forming a sealing layer which covers the metal electrode.

An object of the present invention is to provide a method which needs a transferring/peeling step like a method which accurately fixes/transports a thin-film substrate, can form a pattern without forming air bubbles and deviating the position, can adopt an inexpensive heat resistant substrate, and includes the steps of stacking an element such as an electrode and an insulation layer on a release layer on a temporal substrate, bonding a plastic film which has been separately prepared, on the electrode and the device, and transferring/forming the release layer onto the plastic film, and which eliminates the possibility of the occurrence of insufficient peeling/transferring because of the transferring/peeling step, in a problem of the above described conventional technology, in other words, in a process of forming a pattern on the thin-film substrate to be used for parts in the electronic device, the display and the like.

### SUMMARY OF THE INVENTION

The method according to present invention attempts to solve the above described conventional problems, and can fix the substrate without forming air bubbles and causing distortion, by fixing a thin-film substrate on a hard substrate through a tackiness/adhesive agent, even when the thin-film substrate is used. The present invention is to provide a method which can thereby stably form a pattern without causing the position deviation, and can take out the substrate without a damage after the substrate has been transported. For this purpose, the following means are adopted.

1. A method for manufacturing a thin-film substrate having a pattern formed thereon, including: fixing the thin-film substrate on a tackiness/adhesive agent layer provided on a surface of a hard substrate; then forming a pattern on the thin-film substrate; and subsequently peeling the thin-film substrate at an interface between the thin-film substrate and the tackiness/adhesive agent.
2. The method according to 1, wherein the thin-film substrate includes at least one layer which has a thickness of 2 mm or less, has a glass transition point temperature (Tg) of 23°C or higher, and has an elastic modulus in tension of 300 MPa or more.
3. The method according to any one of 1 and 2, wherein the thin-film substrate has a CTE of 300 ppm or less at 150°C.
4. The method according to any one of 1 to 3, wherein the tackiness/adhesive agent layer includes at least one layer, has a total thickness of 0.01 μm to 3 mm, and has a storage elastic modulus of 1×10⁴ to 1×10⁷ at 23°C to 150°C.
5. The method according to any one of 1 to 4, wherein the tackiness/adhesive agent layer has such a value of tack strength that a measurement value shown after having been heated at 150°C for 1 hour is within three times of a measurement value shown before being heated, and shows a 180-degrees peel tack strength of 1.5 N / 10 mm or less when the thin-film substrate is peeled at a peel rate of 300 mm/min.
6. The method according to any one of 1 to 5, wherein a process of forming the pattern includes one or more times of steps of heating the substrate to 80°C to 270°C.
7. A tackiness/adhesive agent to be used for the tackiness/adhesive agent layer in the method according to any one of 1 to 6.
8. A stacked body including the hard substrate and the tackiness/adhesive agent layer provided on the surface of the hard substrate, which are used for the method according to any one of 1 to 6.

The present invention shows the following effects by adopting the above described means.
Specifically, the tackiness/adhesive agent according to the present invention is a composition having the tackiness and/or adhesiveness, and can form a layer structure formed of at least one layer according to the composition. The tackiness/adhesive agent is a material which primarily and temporarily fixes a thin-film substrate and a hard substrate for pattern formation to each other under a high-temperature atmosphere of 80 to 270°C, and can control the increase of tack strength after having been heated, which enables the thin-film substrate to be peeled off from the tackiness/adhesive agent without causing a damage, peel failure and a defect due to the paste residue, when the thin-film substrate is finally taken out. Thereby, the present invention enhances the availability factor of the apparatus, and can provide an inexpensive circuit member.
Furthermore, the present invention can attain a method that can accurately fix and transport the thin-film substrate, can form a pattern without forming air bubbles and deviating the position, thereby can enhance the yield, can adopt an inexpensive heat-resistant substrate, and can adopt a batch process without using a double-sided tape that has been separately prepared, which is different from a conventional method, and thereby can provide a method for efficiently and stably forming the pattern.

### BRIEF DESCRIPTION OF THE DRAWING

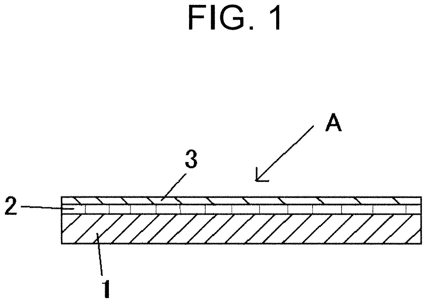

FIG. 1 is a sectional view in which a thin-film substrate is fixed on a hard substrate by using a tackiness/adhesive sheet for fixing the thin-film substrate according to the present invention.

### DETAILED DESCRIPTION OF THE PREFERRED EMBODIMENTS

The present invention is an invention for smoothly conducting a step of peeling a thin-film substrate from a tackiness agent layer, after a hard substrate has been previously prepared, the thin-film substrate has been fixed on the surface of the hard substrate through a tackiness/adhesive agent layer and a pattern has been subsequently formed on the thin-film substrate, when forming the pattern on the thin-film substrate.

### (Pattern)

The pattern in the present invention means a circuit, a thin film, an element and the like, which are formed on the thin-film substrate and are needed for using the thin-film substrate for applications of a flexible printed circuit board (FPC), a base substrate of an organic EL panel, a driving circuit of an electronic paper and a flexible display, a circuit board of a passive matrix or a color filter and a touch panel, a film-forming process of a solar cell and the like.
This pattern may be any pattern necessary for the above described applications, and the shape and the material of the pattern need not be considered.

### (Hard substrate)

Materials to be used for the hard substrate include a glass, a metal plate and a semiconductor wafer, and are not limited at all. Any material is acceptable as long as the material has sufficient strength, can have a layer formed from the tackiness/adhesive agent of the present invention on the substrate, and further can have a thin-film substrate which is an object to have the pattern formed thereon stably stacked on the layer formed from the tackiness/adhesive agent.
The hard substrate has a thickness preferably of 0.01 mm to 10 mm, more preferably of 0.02 mm to 7 mm and further preferably of 0.03 mm to 5 mm. If having the thickness of 0.01 mm to 10 mm, the hard substrate is preferable in the points of easily being held and transported, and having shock resistance. Even in this thickness range, if the hard substrate satisfies holdability and shock resistance, the substrate is further preferably thinner because the substrate is light and is easily transported.

### (Thin-film substrate)

A substrate to be used as a thin-film substrate is a substrate formed of at least one layer or more, and can use materials of polyimide, polycarbonate, polyether sulfone, polyacrylate, polyamide, polynorbornene, polyethylene terephthalate, polyethylene naphthalate, polyetheretherketone, polyamide-imide, polyetherimide, polyaramide, polyphenylene sulfide and a stainless steel foil.
In addition, even other materials than those may also be used without any limitation, as long as the materials can be used for the applications of the above described flexible printed circuit board (FPC), the base substrate of the organic EL panel, the driving circuit of the electronic paper and the flexible display, the passive matrix, the color filter and the like.
Even when the structure of the thin-film substrate is not only a single layer but also a bilayer or a multilayer, there is no problem. In addition, even when a treatment layer is provided on any surface so as to enhance wear resistance, smoothness and moisture resistance, there is also no problem.
The surface roughness of the thin-film substrate is not limited in particular, but the surface to have the pattern formed thereon is preferably smooth. In this point, R max is less than 10 μm, and more preferably is less than 5 μm.
The thickness is 5 μm to 2 mm, preferably is 7 μm to 0.5 mm, and more preferably is 10 μm to 0.3 mm, because the substrate needs to reduce its weight and thickness of the film, and simultaneously needs such a thickness as to be capable of being finally assembled.

The thin-film substrate preferably has the elastic modulus of some level, when it is considered to prevent the thin-film substrate from being bent by handling in a pattern-forming process. Specifically, the elastic modulus of the thin-film substrate is 100 MPa or more, and is more preferably 300 MPa or more. If the film has the elastic modulus of 100 MPa or more, the thin-film substrate does not frequently cause wrinkle/crease while being handled after the pattern has been formed thereon, and a yield is not lowered. Furthermore, the thin-film substrate solves such a defect that a film having a low elastic modulus is generally softened and melted by being heated and is hard to be used.
The thin-film substrate preferably has a glass transition temperature (Tg) of 23°C or higher, in consideration of handling properties and the controllability for distortion at room temperature.

The thin-film substrate is generally treated at 150°C or higher in a heating step particularly when TFT (driving circuit) or a color filter is formed thereon. When a material having a large CTE value (coefficient of linear thermal expansion) is used, the material expands/contracts when the pattern is formed, and deviation and the like occur when the circuit is formed, due to the difference between the CTE values of the thin-film substrate and the hard substrate. As a result, such a problem occurs that the yield is lowered, and accordingly this value is important.
Specifically, the usable thin-film substrate has a CTE value of less than 300 ppm at 150°C, and a thin-film substrate may be used which has the CTE value more preferably of less than 200 ppm, further preferably of less than 150 ppm, and most preferably of less than 100 ppm. When the CTE value at 150°C is 300 ppm or more, the position deviation has occurred when each circuit layer has been formed in the pattern-forming process at 150°C or higher, and as a result, the yield has resulted in being lowered.

### (Tackiness/adhesive agent)

The tackiness/adhesive agent has a role of affixing/fixing a hard substrate and a thin-film substrate to each other, and because of this, needs to be a composition which can fix the thin-film substrate on the hard substrate with sufficient tackiness/adhesiveness. The tackiness/adhesive agent according to the present invention includes an agent which functions as a tackiness agent or an adhesive agent.
Because of this, usable tackiness/adhesive agents include: for instance, an organic-based adhesive agent, specifically such as a natural rubber adhesive agent, an α-olefin-based adhesive agent, a urethane-resin-based adhesive agent, an ethylene-vinyl acetate resin emulsion adhesive agent, an ethylene-vinyl acetate hot-melt adhesive agent, an epoxy-resin-based adhesive agent, a solvent-type vinyl chloride resin adhesive agent, a chloroprene-rubber-based adhesive agent, a cyanoacrylate-based adhesive agent, a silicone-based adhesive agent, a solvent-type styrene-butadiene rubber adhesive agent, a nitrile-rubber-based adhesive agent, a nitrocellulose-based adhesive agent, a reactive hot-melt adhesive agent, a phenol-resin-based adhesive agent, a modified-silicone-based adhesive agent, a polyamide resin hot-melt adhesive agent, a polyimide-based adhesive agent, a polyurethane resin hot-melt adhesive agent, a polyolefin resin hot-melt adhesive agent, a solvent-type polyvinyl acetate resin adhesive agent, a solvent-type polystyrene resin adhesive agent, a polyvinyl-alcohol-based adhesive agent, a polyvinylpyrrolidone-resin-based adhesive agent, a polyvinyl-butyral-based adhesive agent, a polybenzimidazole adhesive agent, a solvent-type polymethacrylate resin adhesive agent, a melamine-resin-based adhesive agent, a urea-resin-based adhesive agent and a resorcinol-based adhesive agent; and tackiness agents of these resins. In addition, other materials may also be used without any limitation.

The tackiness/adhesive agent may use more specifically a rubber-based tackiness/adhesive agent, an acrylic-based tackiness/adhesive agent, a silicone-based tackiness/adhesive agent, a urethane-based tackiness/adhesive agent, and other materials may also be used without any limitation. Here, the acrylic-based tackiness agent will be taken as a specific example, but tackiness/adhesive agents of materials other than the acrylic-based tackiness agent may also be used without any limitation.
In addition, the tackiness/adhesive agent may also contain an appropriate additive such as a crosslinking agent (for instance, polyisocyanate, an alkyl-etherized melamine compound and the like), a tackifier (for instance, a rosin derivative resin, a polyterpene resin, a petroleum resin, an oil-soluble phenol resin and the like), a rubber, a plasticizer, a filler and an antioxidant, in addition to the tackiness component (base polymer).
After such a tackiness/adhesive agent has been previously applied to the hard substrate with a bar coater, the thin-film substrate can be affixed onto the hard substrate, or after the tackiness/adhesive agent has been applied to the thin-film substrate, the thin-film substrate may also be affixed onto the hard substrate.

The tackiness/adhesive agent can be used as a temporarily fixing layer by being appropriately dissolved in an organic solvent or water, being applied to the hard substrate with the use of the bar coater or a Meyer bar, and being subjected to a drying step, as needed.
Alternatively, it is also possible to fix the thin-film substrate on the surface of the hard substrate through the tackiness/adhesive agent layer, by applying the tackiness/adhesive agent which has been appropriately dissolved in an organic solvent or water, to one face of the thin-film substrate, drying the thin-film substrate to thereby form the tackiness/adhesive agent layer on one face of the thin-film substrate, and subsequently affixing the face in the tackiness/adhesive agent layer side onto the surface of the hard substrate.
Furthermore, when the tackiness/adhesive agent layer is provided on the hard substrate or the thin-film substrate, it is possible to adopt means of applying/drying the tackiness/adhesive agent that has been appropriately dissolved in the organic solvent or water, onto a release liner layer, and transferring the thereby obtained tackiness/adhesive agent layer onto the thin-film substrate or the hard substrate.
The thickness of the tackiness/adhesive agent layer at this time is preferably 0.01 μm to 3 mm, and more preferably is 0.02 μm to 2.5 mm. The tackiness/adhesive agent layer may be formed to have a structure having no substrate, and may also have such a structure that the same or different tackiness/adhesive agent is applied to both faces of a substrate through a reinforcing layer formed of at least one layer.
When the thickness is greater than 0.01 μm, a sufficient adhesive strength for fixing the thin-film substrate can be obtained. If the thickness is 3 mm or less, a defect of fixation and a defect of delamination do not possibly occur, because the tackiness agent and the substrate do not receive a damage in a chemical liquid step which corresponds to a posterior step of the pattern-forming step and the chemical liquid does not intrude into the boundary from the end.

The tackiness/adhesive agent preferably has a storage elastic modulus of 1×10⁴ to 1×10⁷ Pa between 23°C and 150°C. If the storage elastic modulus is 1×10⁴ Pa or more, the tackiness/adhesive agent layer can suppress the expansion/contraction of the thin-film substrate occurring when the pattern is formed, consequently does not deform the thin-film substrate, and accordingly does not cause pattern deviation. On the other hand, if the storage elastic modulus is 1×10⁷ Pa or less, the adhesiveness to the hard substrate and the thin-film substrate is obtained, and lifting and peeling do not occur. These storage elastic moduli can be controlled by the addition of silica, a tackifier, a plasticizer, a fluorocarbon resin, a silane coupling agent and the like, in addition to a curing agent including a crosslinking agent, and accordingly there is no problem in particular.
In addition, the tackiness/adhesive agent according to the present invention desirably has such a value of tack strength that a measurement value shown after having been heated at 150°C for 1 hour is within three times of a measurement value shown before being heated, because the pattern is formed under a heating environment of 80°C to 270°C for approximately 20 minutes to 3 hours, in many cases. The tackiness/adhesive sheet having the tack strength after having been heated within three times of the measurement value shown before being heated does not completely follow the fine unevenness of the thin-film substrate, and accordingly it does not occur that the tackiness/adhesive agent sheet is hard to be peeled.

It is also acceptable to reduce the wettability by copolymerizing glycidyl methacrylate with acrylic acid in an acrylic polymer, and thermal-curing the tackiness agent in a heating step when the pattern is formed, in order to reduce the wettability to the thin-film substrate due to the heating of the tackiness agent. As another method, it is also effective to reduce the weight ratio of acrylic acid with respect to the total of an acrylic monomer in the polymerization operation to less than 7%, in order to reduce the increase of the tack strength after heating with respect to that before heating. In addition, even if the plasticizer, the wax, the surface active agent and the silica for reducing the contact area are added to the tackiness agent, there is no problem.

In a peeling step for the thin-film substrate, the 180-degrees peel tack strength at a peel rate of 300 mm/min is 2 N / 10 mm or less, preferably is 1.5 N / 10 mm or less, and further preferably is 1.0 N / 10 mm or less.
If the peel tack strength is 2 N / 10 mm or more, there are such problems that the thin-film substrate is not easily peeled and consequently receives a damage when being peeled, the thin-film substrate and a layer formed thereon are damaged, and a non-defective product ratio results in decreasing. In the peeling process, as a substantial peeling force is closer to zero, a damage is caused less often during the peeling operation, which is more preferable.

Thus, in the pattern-forming process, the tack strength is desirably high. However, after the pattern has been formed on the thin-film substrate, the thin-film substrate needs to be peeled from the tackiness/adhesive agent layer, and accordingly when the thin-film substrate is peeled, it is important for the thin-film substrate to be smoothly peeled without forming a stress/damage therein caused by an excessive force applied to the thin-film substrate.

From such a viewpoint, it is possible to use, for instance, a tackiness/adhesive agent which can lower the tack/adhesive strength by being irradiated with an energy beam such as an ultraviolet light and an electron beam, or a tackiness/adhesive agent layer which can lower the tack/adhesive strength by being heated.
Usable tackiness/adhesive agents which can lower the tack/adhesive strength by being irradiated with the energy beam such as the ultraviolet light and the electron beam include: a tackiness/adhesive agent that uses a polymer in which a C=C-bond is introduced in a polymer backbone, for instance, when an acrylic tackiness/adhesive agent is used; and a tackiness/adhesive agent that is formed by adding a compound which is called as an acrylate and urethane oligomer containing a C=C double bond, and mixing the resultant mixture with a compound which is called a photopolymerization initiator, in an organic solvent.
A predetermined tackiness/adhesive sheet can be obtained by applying the above tackiness/adhesive agent onto the release liner with a bar coater, and drying the applied tackiness/adhesive agent at 120°C for 5 minutes. Thus obtained tackiness/adhesive sheet can easily lower its tack strength by irradiation with the ultraviolet light, as has been described above.

A tackiness/adhesive agent formed by blending a foaming agent of a microcapsule such as "Microsphere series" sold by MATSUMOTO YUSHI-SEIYAKU CO., LTD. into the tackiness agent is adopted as the tackiness/adhesive agent which can lower its tack/adhesive strength by being heated. In the tackiness/adhesive agent layer formed from the applied tackiness/adhesive agent, the microcapsule foams/expands due to heating, thereby produces physical unevenness on an interface between the tackiness/adhesive agent layer and the tacked body, and the adhesion area between the thin-film substrate and the tackiness/adhesive agent layer remarkably decreases, and consequently can change the tack/adhesive strength to the minimum strength. As a result, the thin-film substrate can be easily peeled from the tackiness/adhesive agent layer in which foaming has occurred.
Among them, the tackiness/adhesive agent which can lower its tack strength by being heated is preferably a tackiness/adhesive agent which does not constrain expansion and/or foaming of the foaming agent such as a thermally expansive microsphere when having been heated, as much as possible, and can employ a known tackiness/adhesive agent, for instance, such as a rubber-based tackiness agent, an acrylic-based tackiness agent, a vinyl-alkyl-ether-based tackiness agent, a silicone-based tackiness agent, a polyester-based tackiness agent, a polyamide-based tackiness agent, a urethane-based tackiness agent, a styrene-diene-block-copolymer-based tackiness agent and a creep-characteristics-improved type tackiness agent prepared by blending a thermally meltable resin having a melting point of approximately 200°C or lower with these tackiness agents, solely or in combination with other one or more types.

When the crosslinking agent is added to the above described tackiness/adhesive agent, the amount to be added is preferably 0.01 to 10 parts by weight with respect to 100 parts by weight of the base polymer, and further preferably is 0.01 to 8 parts by weight. For information, the usable crosslinking agent includes crosslinking agents such as an isocyanate-based crosslinking agent, an epoxy-based crosslinking agent, a melamine-based crosslinking agent, a thiuram-based crosslinking agent, a resin-based crosslinking agent and a metal chelate.

Incidentally, a more preferable tackiness/adhesive agent from the viewpoint of the balance between the adequate adhesive strength before heating treatment and the decreasing properties in the adhesive strength after the heating treatment is a pressure-sensitive adhesive agent which contains a polymer having a dynamic elastic modulus in a range of 5,000 to 1 million Pa at room temperature to 150°C, as the base.

The above described thermally expansive microsphere may be, for instance, a microsphere which contains a substance that is easily gasified to expand by heating, such as isobutane, propane and pentane, in a shell having elasticity. The above described shell is formed from a thermally meltable material or a material which is destroyed by thermal expansion, in many cases. The substance which forms the above described shell includes, for instance, a vinylidene chloride - acrylonitrile copolymer, polyvinyl alcohol, polyvinyl butyral, polymethyl methacrylate, polyacrylonitrile, polyvinylidene chloride and polysulfone. The thermally expansive microsphere can be produced with a conventional method, for instance, such as a coacervation method and an interfacial polymerization method. A usable thermally expansive microsphere of the present invention includes, for instance, a commercial product such as "Matsumoto Microsphere F30D and F50D" by a trade name made by MATSUMOTO YUSHI-SEIYAKU CO., LTD.

In addition, the thermally expansive microsphere has preferably such an adequate strength as not to be ruptured until the volume expansion coefficient reaches 5 times or more, more preferably reaches 7 times or more, and particularly preferably reaches 10 times or more, so as to efficiently lower the adhesive strength of the tackiness/adhesive agent layer by heating treatment.

The amount of the foaming agent to be blended such as the thermally expansive microsphere can be appropriately set according to the expansion magnification of the tackiness/adhesive agent layer and the decreasing properties of the tack strength (adhesive strength), but is generally, for instance, 1 to 150 parts by weight with respect to 100 parts by weight of the base polymer (for instance, acrylic polymer in the case of acrylic-based tackiness agent) which constitutes the tackiness/adhesive agent layer, and preferably is 5 to 100 parts by weight. When the above described amount of the foaming agent to be blended such as the thermally expansive microsphere is less than 1 part by weight, sufficient easy peelability cannot be occasionally shown. On the other hand, when the blended amount exceeds 150 parts by weight, the surface of the tackiness/adhesive agent layer is made uneven, and the adhesiveness is occasionally lowered. Particularly, in the present invention, the thin-film substrate may be easily peeled in such a degree that the thin-film substrate is not ruptured, and when a thin tackiness/adhesive agent layer is formed, it is preferable for stably forming the surface state to reduce the blended amount of the foaming agent such as the thermally expansive microsphere to a small amount in some degree. From this point, the optimal blended amount is approximately a half of the blended amount (30 to 80 parts by weight) of the blended amount necessary for complete peeling (tack strength of zero).

An initiation temperature of the thermal expansion of the tackiness/adhesive agent layer of the present invention is appropriately determined according to heat resistance and the like of the thin-film substrate having the circuit formed thereon and the layer formed on the thin-film substrate, and is not limited in particular. The "initiation temperature of thermal expansion" in the present invention is such a temperature that the expansion of the thermally expansive microsphere has started when the foaming agent such as the thermally expansive microsphere is measured with an expansion method (load: 19.6 N and probe: 3 mmφ) with the use of a thermal analysis instrument (a trade name "TMA/SS6100" made by SII NanoTechnology Inc.).

The above described initiation temperature of thermal expansion can be appropriately controlled according to the type, the distribution of particle sizes and the like of the foaming agent such as the thermally expansive microsphere. Particularly, the initiation temperature of the thermal expansion can be easily controlled by classifying the thermally expansive microspheres, and sharpening the distribution of the particle sizes of the thermally expansive microspheres to be used. The classification method can employ a known method, and may employ any method of a dry method and a wet method. The classification device can employ a known classification device, for instance, such as a gravitational classifier, an inertial classifier and a centrifugal classifier.
When the tackiness agent layer contains the thermally expansive microsphere, the thickness of the tackiness agent layer is, for instance, 5 to 300 μm, and preferably is approximately 10 to 200 μm.
In the case of the tackiness/adhesive agent layer containing the thermally expansive microsphere, the thickness may be thicker than the maximum particle size of the contained thermally expansive microspheres, and in this case, the thermally expansive microspheres do not form unevenness on the surface of the layer formed from the tackiness/adhesive agent.

### (Separator)

In the present invention, a release liner can be occasionally stacked on the tackiness/adhesive agent layer as a separator for the purpose of preventing the staining of the surface of the tackiness/adhesive agent layer, before the thin-film substrate is stacked on the tackiness/adhesive agent layer, after the tackiness/adhesive agent layer has been formed.
The separator to be used is not limited in particular, and can employ a known release paper or the like. The usable separator includes: for instance, a substrate having a release layer such as a plastic film or a paper which has been surface-treated with a release agent such as a silicone-based release agent, a long-chain-alkyl-based release agent, a fluorocarbon-based release agent and a molybdenum-sulfide-based release agent; a low-adhesiveness substrate formed from a fluorocarbon-based polymer such as polytetrafluoroethylene, polychlorotrifluoroethylene, polyvinyl fluoride, polyvinylidene fluoride, a tetrafluoroethylene-hexafluoropropylene copolymer and a chlorofluoroethylene-vinylidene fluoride copolymer; and a low-adhesiveness substrate formed from a nonpolar polymer such as an olefin-based resin (for instance, polyethylene and polypropylene).

### (Step of manufacturing flexible printed circuit board)

When a flexible printed circuit board is manufactured by using the tackiness/adhesive agent according to the present invention, the flexible printed circuit board is manufactured by forming a circuit or an element on a substrate film of the flexible printed circuit board, in a state in which the substrate film of the flexible printed circuit board that is a thin-film substrate is temporarily fixed by a tackiness/adhesive agent layer that has been formed on a hard substrate, or by implementing an element in the state.

The flexible printed circuit board is specifically manufactured, firstly, by temporarily fixing the substrate film of the flexible printed circuit board onto the hard substrate through the tackiness/adhesive agent layer, forming the circuit on the substrate film of the temporarily fixed flexible printed circuit board, and then fixing the element. The hard substrate for fixing the above described substrate film of the flexible printed circuit board thereon may be any hard substrate as long as the hard substrate can hold the substrate film of the flexible printed circuit board thereon, and is not limited in particular. However, a material to be preferably used is a harder material than the substrate film of the flexible printed circuit board, and includes, for instance, silicon, a glass, an SUS plate, a copper plate and an acrylic plate. The thickness of the hard substrate is 0.01 to 10 mm, and further preferably is 0.4 mm or more (for instance, 0.4 to 5.0 mm).

A method of affixing the film for the flexible printed circuit board onto the hard substrate through the tackiness/adhesive agent layer may be any method as long as the method can bond the hard substrate and the film for the flexible printed circuit board to each other, and the film can be affixed to the substrate, for instance, by using a roller, a spatula, a pressing machine or the like.

The substrate material constituting the flexible printed circuit board is not limited in particular as long as the substrate material is a material having heat resistance, dimension stability, gas barrier properties and surface smoothness, and can employ a film, for instance, formed from polycarbonate, polyethylene terephthalate (PET), polyethylene naphthalate (PEN), a cyclic olefin-based polymer, polyarylate, an aromatic polyether ketone, an aromatic polyether sulfone, a wholly aromatic polyketone, a liquid crystal polymer, polyimide and the like. In addition, a coating film may also be formed on these films so as to enhance the gas barrier properties, as needed.
In addition, a copper-clad laminate, a membrane wiring board and a multilayer flexible printed circuit board may also be adopted as a substrate material, and a substrate having a via hole formed therein by the processing can also be used.

The thickness of these films is, for instance, approximately 800 μm or less, except the thickness of a wiring portion, preferably is approximately 5 to 700 μm, and particularly preferably is approximately 5 to 600 μm.

The flexible printed circuit board can be each of flexible printed circuit boards of a single-sided circuit, a double-sided circuit and a multilayered circuit; and has not only the circuit formed thereon but also can implement an element or the like thereon. In order to form a circuit on both faces of the thin-film substrate, means can be adopted which forms the circuit on one face, fixes the face having the circuit formed thereon on a hard substrate through a tackiness/adhesive agent, and forms the circuit on the other face.
The organic transistor material to be formed on the substrate film of the flexible printed circuit board is not limited in particular, and can employ a low-molecular-based organic semiconductor material, a high-polymer-based organic semiconductor material and an organic-inorganic hybrid semiconductor material. A gate insulation material can employ an organic polymer material and an inorganic material.

Means for forming the organic transistor can be a transferring method, but an electrode or a wire can be formed by directly drawing the shape on the film. The material for the electrode and the wire can adopt a metal nano-paste or a metal nano-ink which contains nanoparticles of a metal such as silver, and a paste or an ink which contains nanoparticles of a metal oxide. The solution and the like of an electroconductive polymer may also be adopted.
The drawing method for these transistors and electrode/wire can adopt an ink jet method, a screen printing method, a gravure printing method, a flexographic printing method, and a nano-print technology. Furthermore, a TFT circuit and the like may also be formed on the film with the transferring method.

A layer necessary for further forming a display layer such as a liquid crystal display and an organic EL display can be formed on the flexible printed circuit board to be manufactured in this way, and is processed so as to have a layer structure corresponding to each display.

In the method for manufacturing the flexible printed circuit board, it is preferable to further prepare a step of peeling the flexible printed circuit board from the hard substrate after the step of manufacturing the flexible printed circuit board. A peeled flexible printed circuit board is collected with a widely known ordinary method.

In addition, in the step of peeling the flexible printed circuit board, it is more preferable to lower the tack/adhesive strength of the tackiness/adhesive agent layer, and peel the flexible printed circuit board obtained through the step of forming the flexible printed circuit board from a supporting plate.

When the substrate film is temporarily fixed on the hard substrate by using the tackiness/adhesive agent having an active energy beam curing type tackiness agent layer as a tackiness/adhesive agent layer, the tack/adhesive strength can be lowered by being irradiated with an active energy beam (for instance, ultraviolet light). The irradiation condition such as an irradiation intensity and an irradiation period of time of the irradiation by the active energy beam is not limited in particular, and can be appropriately set, as needed.
However, when the organic EL panel is peeled from the supporting plate while lowering the tack/adhesive strength by heating, in consideration of the heat-resistant temperature of the flexible printed circuit board, the heating temperature should be controlled to a temperature lower than the heat-resistant temperature, and in this point, means for peeling the substrate while lowering the tack/adhesive strength by the active energy beam such as the ultraviolet light is preferable.

When the substrate film is temporarily fixed on the hard substrate by using the tackiness/adhesive agent having the previously described thermally peelable type tackiness agent layer as a tackiness/adhesive agent layer, the tack/adhesive strength can be lowered by being heated. The heating means may be capable of promptly expanding and/or foaming the foaming agent such as a thermally expansive microsphere contained in the tackiness/adhesive agent layer by heating the tackiness/adhesive agent layer, and can employ, for instance, an electrical heater; dielectric heating; magnetic heating; heating by an electromagnetic wave such as near-infrared rays, middle-infrared rays and far-infrared rays; and an oven and a hot plate, without being particularly limited.
The heating temperature may be a temperature at which the thermally expansive microspheres contained in the tackiness/adhesive agent layer expand and/or foam and the formed flexible printed circuit board is not damaged, and is not limited in particular.

### (Step of manufacturing organic EL panel)

When an organic EL panel is manufactured by using the tackiness/adhesive agent according to the present invention, the organic EL panel is manufactured by forming a light-emitting layer, a layer for adjusting a wavelength, a cover layer and the like on a supporting film for the organic EL panel, in such a state that the supporting film for the organic EL panel which is a thin-film substrate is temporarily fixed by the tackiness/adhesive agent layer that is formed on a hard substrate.

Specifically, as the thin-film substrate in the present invention, a resin film is adopted which is covered with a metal oxide, as needed. The organic EL panel is obtained by temporarily fixing the resin film on the hard substrate through the tackiness/adhesive agent layer, and forming an insulation layer, ITO, indium oxide, IZO, an electrode of silver or the like, a hole-transporting layer, a light-emitting layer, an electron-transporting layer, an RGB color filter and the like in an arbitrary order, on the temporarily-fixed resin film. A material constituting the above described hard substrate may be any material as long as the material can hold a thin-film substrate to be affixed thereto, and is not limited in particular. However, a material to be preferably used is a harder material than the supporting film for the organic EL panel, and includes, for instance, silicon, glass, an SUS plate, a copper plate and an acrylic plate. The thickness of such a hard substrate is 0.01 to 10 mm, and further preferably is 0.4 mm or more (for instance, 0.4 to 5.0 mm).

A method of affixing the supporting film for the organic EL panel onto the hard substrate through the tackiness/adhesive agent layer may be any method as long as the method can bond the hard substrate and supporting film for the organic EL panel to each other, and the film can be affixed to the substrate, for instance, by using a roller, a spatula, a pressing machine or the like.

A material constituting the supporting film for the organic EL panel, which is a thin-film substrate, is not limited in particular, as long as the material is excellent in smoothness, gas barrier properties and water-vapor barrier properties and can show flexibility also after each layer necessary for light emission has been formed; and can employ, for instance, a film which is formed from polyethylene terephthalate (PET), polyimide or an aromatic polyether sulfone and may be covered with a resin layer or a barrier layer such as a silicon oxide layer and a silicon nitride layer, and further an extremely thin glass occasionally.

The thickness of such a supporting film for an organic EL panel is, for instance, approximately 3 mm or less, preferably is approximately 10 μm to 2.5 mm, and particularly preferably is approximately 15 μm to 2.5 mm.

Each layer for the organic EL to be formed on the supporting film for the organic EL panel has the same stacked structure as that of each layer for the conventional organic EL to be provided on a glass substrate, except the layer for enhancing the gas barrier properties and the water-vapor barrier properties. The stacking means for each layer can adopt the same means as the stacking means for each layer onto the glass substrate.

The organic EL panel to be obtained is not limited in particular, and may be any of known types such as an active-type full color panel, a color flexible panel, a panel having a high-polymer hole-transporting layer and a passive-type high-polymer organic EL panel.

In the method for manufacturing the organic EL panel, it is preferable to further prepare a step of peeling the organic EL panel from the hard substrate after the step of manufacturing the organic EL panel. A peeled organic EL panel is collected with a widely known method.

In addition, it is more preferable in the step of peeling the organic EL panel to lower the tack/adhesive strength of the tackiness/adhesive agent layer, and peel the organic EL panel obtained through the step of forming the organic EL panel, from the hard substrate.

When the organic EL panel is temporarily fixed on the supporting plate by using the tackiness/adhesive agent having an active energy beam curing type tackiness agent layer as a tackiness/adhesive agent layer, the tack/adhesive strength can be lowered by being irradiated with an active energy beam (for instance, ultraviolet light). The irradiation condition such as irradiation intensity and an irradiation period of time of the irradiation by the active energy beam is not limited in particular, and can be appropriately set, as needed.
However, when the organic EL panel is peeled from the hard substrate while lowering the tack/adhesive strength by heating, in consideration of the heat-resistant temperature of the organic EL panel, the heating temperature should be controlled to a temperature lower than the heat-resistant temperature, and in this point, means for peeling the substrate while lowering the tack/adhesive strength by the active energy beam such as the ultraviolet light is preferable.

When the organic EL panel is temporarily fixed on the hard substrate by using the tackiness/adhesive agent having the thermally peelable type tackiness agent layer as a tackiness/adhesive agent layer, the tack/adhesive strength can be lowered by being heated. The heating means may be capable of promptly expanding and/or foaming the foaming agent such as the thermally expansive microsphere contained in the tackiness/adhesive agent layer by heating the tackiness/adhesive agent layer, and can employ, for instance, an electrical heater; dielectric heating; magnetic heating; heating by an electromagnetic wave such as near-infrared rays, middle-infrared rays and far-infrared rays; and an oven and a hot plate, without being particularly limited.
The heating temperature may be a temperature at which the foaming agent such as the thermally expansive microsphere contained in the tackiness/adhesive agent layer expands and/or foams and the formed organic EL panel is not damaged; and is, for instance, 70 to 200°C, and is preferably 100 to 160°C approximately.

### (Step of manufacturing electronic paper)

When an electronic paper is manufactured by using the tackiness/adhesive agent according to the present invention, the electronic paper is manufactured by forming a TFT on a supporting film of the electronic paper to obtain a driver layer, and further affixing a display layer having an image display function onto the driver layer, in such a state that the supporting film of the electronic paper which is a thin-film substrate is temporarily fixed by the tackiness/adhesive agent layer that is formed on a hard substrate.

The driver layer is specifically obtained, firstly, by temporarily fixing the supporting film of the electronic paper onto the hard substrate through the tackiness/adhesive agent layer, and forming the TFT on the temporarily fixed supporting film of the electronic paper. The material constituting the above described hard substrate may be any material as long as the material can hold the supporting film of the electronic paper to be affixed thereto, and is not limited in particular. However, a material to be preferably used is a harder material than the supporting film of the electronic paper, and includes, for instance, silicon, glass, an SUS plate, a copper plate and an acrylic plate. The thickness of such a hard substrate is 0.01 to 10 mm, and further preferably is 0.4 mm or more (for instance, 0.4 to 5.0 mm).

A method of affixing the supporting film of the electronic paper onto the hard substrate through the tackiness/adhesive agent layer may be any method as long as the method can bond the hard substrate and the supporting film of the electronic paper to each other, and the film can be affixed to the substrate, for instance, by using a roller, a spatula, a pressing machine or the like.

A material constituting the supporting film of the electronic paper is not limited in particular, as long as the material can show flexibility after having been affixed with the display layer, and can employ, a film, for instance, formed from a polyester such as polyethylene terephthalate (PET) and polyethylene naphthalate (PEN). In addition, the supporting film of the electronic paper may be a transparent film and may also be an opaque film. The supporting film may further be a color-printed film, a colorant-containing film, also a vapor-deposited film which has been vapor-deposited with gold, silver or aluminum, or also a film having an insulation layer formed thereon, as needed.

The thickness of the supporting film of the electronic paper is, for instance, approximately 800 μm or less, preferably is approximately 5 to 700 μm, and particularly preferably is approximately 10 to 600 μm.

The type of the TFT to be formed on the supporting film of the electronic paper is not limited in particular, and the types which can be formed include, for instance, a staggered type, an inverted staggered type, a coplanar type and an inverted coplanar type. A semiconductor layer, a gate insulation film and an electrode, a protection insulation film and the like which constitute a transistor can be formed on the supporting film of the electronic paper in a form of a thin film, with a vacuum vapor-deposition method, a sputtering method, a plasma CVD method, a photoresist method or the like, similarly to a method of forming a usual TFT.

The display layer is a layer having an image display function. The image display type of the display layer is not limited in particular, as long as the image display type has a display function by electricity or magnetism, and can adopt, for instance, a twist ball type, an electrophoresis type and a chargeable toner display type.

The method for affixing the display layer to the supporting film of the electronic paper having the TFT formed thereon may be any method as long as the method can bond the display layer and the supporting film of the electronic paper having the TFT formed thereon to each other, and the display layer can be affixed to the film, for instance, by using a roller, a spatula, a pressing machine or the like.
In addition, when the tackiness agent layer is provided on the rear surface of the display layer so as to be bonded with the supporting film of the electronic paper having the TFT formed thereon, it is not necessary to use a general adhesive agent in particular, but when the tackiness agent layer is not provided on the rear surface of the display layer, the supporting film of the electronic paper having the TFT formed thereon can be bonded with the display layer by using the general adhesive agent.

In the method for manufacturing the electronic paper according to the present invention, it is preferable to further prepare a step of peeling the electronic paper from the hard substrate after the step of forming the electronic paper. The peeled electronic paper is collected with a widely known method.

In addition, it is more preferable in the step of peeling the electronic paper to lower the tack/adhesive strength of the tackiness/adhesive agent layer, and peel the electronic paper obtained through the step of forming the electronic paper from the hard substrate.

When the supporting film is temporarily fixed on the hard substrate by using the tackiness/adhesive agent having an active energy beam curing type tackiness agent layer as a tackiness/adhesive agent layer, the tack/adhesive strength can be lowered by being irradiated with an active energy beam (for instance, ultraviolet light). The irradiation condition such as an irradiation intensity and an irradiation period of time of the irradiation by the active energy beam is not limited in particular, and can be appropriately set, as needed.

When the supporting film is temporarily fixed on the hard substrate by using the tackiness/adhesive agent having the thermally peelable type tackiness agent layer as a tackiness/adhesive agent layer, the tack/adhesive strength can be lowered by being heated. The heating means may be capable of promptly expanding and/or foaming the foaming agent such as a thermally expansive microsphere contained in the tackiness/adhesive agent layer by heating the tackiness/adhesive agent layer, and can employ, for instance, an electrical heater; dielectric heating; magnetic heating; heating by an electromagnetic wave such as near-infrared rays, middle-infrared rays and far-infrared rays; and an oven and a hot plate, without being particularly limited.
The heating temperature may be a temperature at which the foaming agent such as the thermally expansive microspheres contained in the tackiness/adhesive agent layer expand and/or foam, and is not limited in particular.

### (Measurement method)

### Measurement of physical properties of thin-film substrate

Measurement of elastic modulus: the elastic modulus was measured by cutting a sample into a strip shape with a width of 3 mm, sandwiching the cut strip with a chuck for a tensile test, and conducting the tensile test using TENSILON in an MD direction and a TD direction. The maximum Young's modulus obtained by the measurement on conditions of a distance between chucks of 50 mm and a peel rate of 300 mm/min was calculated as an elastic modulus (MPa).

CTE measurement: TMA measurement was conducted in the MD direction and the TD direction by cutting the sample into strip shapes each with a width of 3 mm and sandwiching the cut strip with the chuck for a tensile test. An average coefficient of the linear expansion was measured at 140°C to 160°C in the TD and the MD with the use of a device TMA/SS6000 made by SII NanoTechnology Inc. and a measurement mode of a tensile method, at a load of 19.6 mN, with a distance between chucks of 10 mm, with a temperature program of room temperature to 200°C, at a temperature-raising speed of 5°C/min, and under a measurement atmosphere of nitrogen (flow rate of 200 ml/min). The maximum value was calculated as a CTE value at 150°C.

### Measurement of characteristics of tackiness/adhesive agent

### Measurement of storage elastic modulus

Dynamic viscoelasticity measurement instrument: the dynamic viscoelasticity was measured on at 23°C to 160°C with the use of Rheometrics ARES, on conditions of a frequency of 1 Hz, a plate diameter of 7.9 mm, a distortion of 1% and a sample thickness of 3 mm. Then, G' at 150°C was calculated as a value of a storage elastic modulus.

Initial tack strength: the tackiness/adhesive agent was applied onto a PET substrate so that the thickness of the film after having been dried becomes 30 μm. A PI film made by Toray Industries, Inc. (Kapton 150 EN: 37.5 μm in thickness) with a width of 10 mm was affixed onto the tackiness agent face on a condition of 2 kg roller and one stroke, in such a state that the tackiness/adhesive agent layer directed upward and the PET substrate face directed downward, and then the obtained sample was fixed onto a SUS substrate through a double-sided tape. After thus obtained sample had been left at rest for 30 minutes, the tack strength was measured by peeling the PI film made by Toray Industries, Inc. from the tackiness/adhesive agent layer, at a peel rate of 300 mm/min and a peel angle of 180 degrees.

### Tack strength after having been heated

The above described sample was charged into a drier, was heat-treated at 150°C for 1 hour, and was left at rest for 30 minutes.
After that, the tack strength was measured on the same measurement condition as that when the initial tack strength was measured.

### Ratio of tack strength after heating to initial value

The ratio was calculated from the above described initial tack strength value and tack strength value after heating.

### (Evaluation)

### Position deviation/lifting of substrate in heating

A tackiness/adhesive agent layer was formed by applying a tackiness/adhesive agent onto a glass (0.5 mm in thickness) which corresponded to the hard substrate, so as to become a size of 600 mm x 600 mm. The Kapton 150EN (37.5 μm in thickness) made by Toray Industries, Inc. was fixed further on the tackiness/adhesive agent layer as a thin-film substrate by affixation. A marked line was drawn on the same position on the substrate/glass at a space of 0.5 mm.
After that, the sample was charged into a drier on a condition of 150°C and 1 hour, was taken out from the drier, and was left at rest at room temperature for 30 minutes. The sample in which the position of the marked line at the outermost circumference deviated by 1 mm or more between the thin-film substrate and the film was evaluated to have position deviation, and the substrate in which the position deviated by 0.5 mm or less was evaluated to have no position deviation (N = 3). In addition, concerning the substrate in which lifting had occurred between the tackiness/adhesive agent layer and the thin-film substrate when having been taken out, the ratio (%) of a lifting area with respect to the whole area was recorded.

### Peelability after heating

The sample in which the position deviation and the lifting due to heating had been observed was finally peeled at 180 degrees and at a peel rate of 300 mm/min.
A sample was recorded to be adequate in which the thin-film substrate did not cause a curl after having been peeled, and a sample was recorded to have the curl, in which the thin-film substrate caused the curl. Furthermore, a sample was recorded to resist being peeled, in which the thin-film substrate was tried to be peeled but resisted being peeled.
In addition, an ultraviolet curing type tackiness agent was irradiated with UV through a glass face so that an illuminance was 50 mW/cm² and an integrated light amount was 800 mJ/cm², before being peeled, by using a UV irradiation machine (with the use of high-pressure mercury lamp) of UM-810 made by Nitto Seiki Co., Ltd., and then the thin-film substrate was peeled.

### (Example 1)

Methoxyethyl acrylate in an amount of 60 mol was copolymerized with 22 mol of acryloylmorpholine and 16 mol of 2-hydroxyethyl acrylate in an ethyl acetate with a conventional method. Such an addition reaction was conducted that NCO groups in 2-methacryloyloxyethylene isocyanate were added to 50% of OH groups in the side chain terminals of 2-hydroxyethyl acrylate, and a solution was obtained which contained an acrylic copolymer that had a weight average molecular weight of 900,000 and had carbon-carbon double bonds given in the terminals.
Next, 3 parts by weight of a photopolymerization initiator (trade name "IRGACURE 127" made by BASF) and 3 parts by weight of polyisocyanate compound (trade name "CORONATE L" made by Nippon Polyurethane Industry Co., Ltd.) were added to 100 parts by weight of the solution containing the acrylic copolymer, and a solution of an acrylic ultraviolet-curing-type tackiness agent was obtained.
The solution of the tackiness agent was applied onto a glass which was a hard substrate, and the glass was heated at 120°C for 5 minutes, which caused crosslinking in the tackiness agent. Thereby, a tackiness agent layer was obtained which had a thickness of 30 μm. In addition, a PET tape for measuring the tack strength thereby was prepared by applying the solution of the tackiness agent onto a PET film which had been subjected to corona treatment, and heating the PET film on similar conditions to those in the above description to cause crosslinking in the tackiness agent.

### (Example 2)

A solution containing an acrylic copolymer with a molecular weight of 800,000 was obtained by copolymerizing 100 parts by weight of 2-ethyl hexyl acrylate with 10 parts by weight of 2-hydroxyethyl acrylate in ethyl acetate, with a conventional method. Next, 5 parts by weight of polyisocyanate compound (trade name "CORONATE L" made by Nippon Polyurethane Industry Co., Ltd.) was added to 100 parts by weight of the solution containing the acrylic copolymer, and a solution of an acrylic tackiness agent was obtained.
By using these solutions of the tackiness agents, the tackiness agent layer having a thickness of 30 μm and the PET tape were prepared on similar conditions to those in Example 1.

### (Example 3)

A solution containing an acrylic copolymer with a molecular weight 500,000 was obtained by copolymerizing 100 parts by weight of 2-ethyl hexyl acrylate with 2 parts by weight of acrylic acid in ethyl acetate, with a conventional method.
Next, 1 part by weight of an epoxy compound (trade name "TETRAD-C" made by Mitsubishi Gas Chemical Company, Inc.) was added to 100 parts by weight of the solution containing the acrylic copolymer, and a solution of an acrylic tackiness agent was obtained.
By using these solutions of the tackiness agents, the tackiness agent layer having a thickness of 30 μm and the PET tape were prepared on similar conditions to those in Example 1.

### (Example 4)

The tackiness agent layer and the PET tape were prepared in all similar steps to those in Example 1, except that Teonex Film Q51 (38 μm in thickness) made by Teijin DuPont Films Japan Limited was used as the thin-film substrate.

### (Comparative Example 1)

A solution containing an acrylic copolymer with a molecular weight 500,000 was obtained by copolymerizing 30 parts by weight of 2-ethyl hexyl acrylate with 70 parts by weight of methyl acrylate and 10 parts by weight of acrylic acid in toluene, with a conventional method. Next, 0.05 parts by weight of an epoxy compound (trade name "TETRAD-C" made by Mitsubishi Gas Chemical Company, Inc.) was added to 100 parts by weight of the solution containing the acrylic copolymer, and a solution of an acrylic tackiness agent was obtained.
By using these solutions of the tackiness agents, the tackiness agent layer having a thickness of 30 μm and the PET tape were prepared on similar conditions to those in Example 1.

### (Comparative Example 2)

The solution of the acrylic ultraviolet-curing-type tackiness agent of Example 1 was employed, and the solution of the tackiness agent was applied onto a glass which was the hard substrate. Then, the glass was heated at 120°C for 5 minutes, which caused crosslinking in the tackiness agent. Thereby, a tackiness agent layer was obtained which had a thickness of 30 μm. After this, a PET film separator which had been subjected to release treatment by silicone was affixed on the tackiness agent face, and the tackiness agent was irradiated with UV through a glass face so that an illuminance was 50 mW/cm² and an integrated light amount was 800 mJ/cm², by using UM-810 made by Nitto Seiki Co., Ltd. After that, the PET film separator was peeled and the tackiness agent layer was obtained.
In addition, the above described solution of the tackiness agent was applied onto a PET film which had been subjected to corona treatment, and then the resultant PET film was heated on similar conditions to those in the above description, which caused crosslinking in the tackiness agent. After that, a PET film separator which had been subjected to release treatment by silicone was affixed on the tackiness agent face, and the tackiness agent was irradiated with UV through a glass face so that an illuminance was 50 mW/cm² and an integrated light amount was 800 mJ/cm², by using UM-810 made by Nitto Seiki Co., Ltd. After that, the PET film separator was peeled and the PET tape was prepared.

### (Comparative Example 3)

The tackiness agent layer and the PET tape were prepared on similar conditions to those in Example 2, except that a substrate was used as the thin-film substrate, which was prepared by extruding an ethylene - vinyl acetate copolymer (18 wt% vinyl acetate by content) so as to have a thickness of 100 μm and an elastic modulus of 80 MPa.
The thin-film substrate resulted in being softened and melted at 100°C, and could not be subjected to CTE measurement and various heating evaluations.

**[Table 1]**

| (Experimental result) | | | | | | | | |
|---|---|---|---|---|---|---|---|---|
| | | | | | | | Elastic modulus of tackiness agent | Elastic modulus of substrate |
| | | Example 1 | Example 2 | Example 3 | Example 4 | Comparative Example 1 | Comparative Example 2 | Comparative Example 3 |
| Thin-film substrate | Thickness (µm) | 37.5 | 37.5 | 37.5 | 38 | 37.5 | 37.5 | 100 |
| | Elastic modulus (MPa) | 5800 | 5800 | 5800 | 620 | 5800 | 5800 | 80 |
| | CTE value | 16 | 16 | 16 | 98 | 16 | 16 | - |
| Tackiness/adhesive agent | Storage elastic modulus at room temperature (MPa) | 1.2 | 0.6 | 0.5 | 1.2 | 1.0 | 150 | 0.6 |
| | Storage elastic modulus at I 50°C MPa) | 1.1 | 0.4 | 0.5 | 1.1 | 0.009 | 135 | 0.4 |
| | Initial tack strength (N/10 mm) | 5.3(0.09) | 0.2 | 0.2 | 4.8(0.10) | 1.9 | 0.001 | 0.8 |
| | Tack strength after heating (N110 mm) | 10.1(0.17) | 0.6 | 0.45 | 9.0(0.18) | 7 | 0.005 | - |
| | Ratio of tack strength | 1.9(1.8) | 3.0 | 2.3 | 1.9(1.8) | 3.7 | 5.0 | - |
| Evaluation | Position deviation of substrate in heating | Absence | Absence | Absence | Absence | Presence | Presence | - |
| | Lifting of substrate in heating | 0% | 0% | 0% | 0% | 10% | 70% | - |
| | Peelability after heating | Good | Good | Good | Good | Peel failure | Good | - |

| | | | | | | | | |
|---|---|---|---|---|---|---|---|---|
| As for an ultraviolet curing type tackiness agent, the tack strength after irradiation with ultraviolet light is indicated in ( ). | | | | | | | | |

It can be confirmed that Examples 1 to 4 use such tackiness/adhesive agents and thin-film substrates as to satisfy the requirements specified in the present invention, thereby do not cause the position deviation or lifting of the thin-film substrate even when having been heated, and show such a remarkable effect that peelability after heating is good.
In Comparative Example 1, the used tackiness/adhesive agent has a storage elastic modulus at room temperature of 1.0, but has such a low storage elastic modulus at 150°C as 0.009 MPa, and accordingly even if other initial tack strength and tack strength after heating are appropriate, the tackiness/adhesive agent layer cannot suppress the expansion or contraction of the thin-film substrate to result in causing deformation in the thin-film substrate. Because of this, Comparative Example 1 resulted in causing position deviation in the thin-film substrate and also the lifting of the thin-film substrate when having been heated, and resulted in aggravating the peelability to cause a peel failure.
In Comparative Example 2, the used tackiness/adhesive agent has excessively high storage elastic moduli at room temperature and 150°C, and accordingly the adhesiveness to the hard substrate and the thin-film substrate is insufficient. Because of this, the peelability after heating was good, but the deviation and lifting of the thin-film substrate occurred in heating.
In Comparative Example 3, the thin-film substrate having the elastic modulus of 80 MPa was used. As a result, the thin-film substrate could not be subjected to necessary treatment for evaluation, because it was so difficult to be handled.

### Description of Symbols

1 ... Hard substrate
2 ... Tackiness/adhesive agent layer
3 ... Thin-film substrate
A ... Patterning

## Claims

1. A method for manufacturing a thin-film substrate having a pattern formed thereon, comprising: fixing the thin-film substrate on a tackiness/adhesive agent layer provided on a surface of a hard substrate; then forming a pattern on the thin-film substrate; and subsequently peeling the thin-film substrate at an interface between the thin-film substrate and the tackiness/adhesive agent.

2. The method for manufacturing the thin-film substrate according to claim 1, wherein the thin-film substrate comprises at least one layer which has a thickness of 2 mm or less, has a glass transition point temperature (Tg) of 23°C or higher, and has an elastic modulus in tension of 300 MPa or more.

3. The method for manufacturing the thin-film substrate according to claim 1 or 2, wherein the thin-film substrate has a CTE of 300 ppm or less at 150°C.

4. The method for manufacturing the thin-film substrate according to any one of claims 1 to 3, wherein the tackiness/adhesive agent layer comprises at least one layer or more, has a total thickness of 0.01 µm to 3 mm, and has a storage elastic modulus of 1×10⁴ to 1×10⁷ at 23°C to 150°C.

5. The method for manufacturing the thin-film substrate according to any one of claims 1 to 4, wherein the tackiness/adhesive agent layer has such a value of tack strength that a measurement value shown after having been heated at 150°C for 1 hour is within three times of a measurement value shown before being heated, and shows a 180-degrees peel tack strength of 1.5 N / 10 mm or less when the thin-film substrate is peeled at a peel rate of 300 mm/min.

6. The method for manufacturing the thin-film substrate according to any one of claims 1 to 5, wherein a process of forming the pattern comprises one or more times of steps of heating the substrate to 80°C to 270°C.

7. A tackiness/adhesive agent to be used for the tackiness/adhesive agent layer in the method for manufacturing the thin-film substrate according to any one of claims 1 to 6.

8. A stacked body comprising the hard substrate and the tackiness/adhesive agent layer provided on the surface of the hard substrate, which are used in the method for manufacturing the thin-film substrate according to any one of claims 1 to 6.
